# FASCICULE DE BREVET EUROPEEN

(11) **EP 2 044 474 B1**
(45) Date de publication et mention de la délivrance du brevet: **11.12.2019**
(21) Numéro de dépôt: 07787620.9
(22) Date de dépôt: 17.07.2007
(51) Int. Cl.: G02B 5/28, G02B 5/20, H01L 27/146

(54) **STRUCTURE MATRICIELLE DE FILTRAGE OPTIQUE ET CAPTEUR D'IMAGES ASSOCIÉ**
MATRIXSTRUKTUR FÜR OPTISCHE FILTER UND DETEKTOR MIT DERSELBEN
OPTICAL FILTER MATRIX STRUCTURE AND ASSOCIATED IMAGE SENSOR

(30) Priorité: 25.07.2006 FR 0653093
(43) Date de publication de la demande: 08.04.2009
(73) Titulaire: Commissariat à l'Énergie Atomique et aux Énergies Alternatives, 75015 Paris (FR)
(72) Inventeur: GIDON, Pierre, F-38130 Echirolles (FR); GRAND, Gilles, F-38000 Grenoble (FR)
(74) Mandataire: Ilgart, Jean-Christophe
(86) Numéro de dépôt international: PCT/EP2007/057354
(87) Numéro de publication internationale: WO 2008/012235

(56) Documents cités:
- EP-A- 1 592 067
- JP-A- 1 271 706
- JP-A- 4 053 166
- US-A1- 2005 003 659
- US-A1- 2005 122 417
- US-A1- 2006 145 223
- US-B1- 6 262 830

## Description

### Domaine technique et art antérieur

L'invention concerne une structure matricielle de filtrage optique et un capteur d'images qui comprend une structure matricielle de filtrage optique selon l'invention.

L'invention trouve une application particulièrement avantageuse pour la réalisation de capteurs d'images de petites dimensions tels que, par exemple, les capteurs d'images d'appareils photographiques miniatures des téléphones mobiles.

L'obtention d'images par capteur électronique est en pleine expansion. La demande de simplification de la réalisation de ces capteurs continue à être très forte. Progressivement, les dispositifs à couplage de charges, plus communément appelés capteurs CCD (CCD pour « Charge Coupled Device »), sont remplacés par les capteurs à pixels actifs en technologie CMOS, plus communément appelés capteurs APS CMOS (APS pour « Active Pixel Sensor »).

Un des problèmes importants à résoudre pour réaliser un capteur d'images est celui de l'obtention des couleurs. Il est connu qu'à partir de trois couleurs prélevées dans le spectre visible (rouge, vert, bleu) il est possible d'enregistrer, puis de reproduire, la majeure partie des couleurs.

Certains équipements commencent par séparer les trois bandes de couleurs puis dirigent celles-ci vers trois capteurs d'images. D'autres séparent les couleurs directement à la surface d'une seule matrice de détecteurs : c'est à ce deuxième type de capteurs que se rapporte l'invention.

Pour ce deuxième type de capteur, deux options peuvent être envisagées :
- soit construire une matrice de détection très complexe exploitant dans plusieurs niveaux de sa structure le fait que les différentes couleurs ne pénètrent pas à la même profondeur dans le matériau dans lequel est faite la conversion des photons en électrons (photo-site);
- soit ajouter des jeux de filtres disposés en matrice à la surface d'une matrice de détecteurs.

C'est la deuxième option (ajouter des jeux de filtres disposés en matrice à la surface d'une matrice de détecteurs) qui est la plus utilisée. La matrice la plus classique est alors une matrice communément appelée matrice de Bayer.

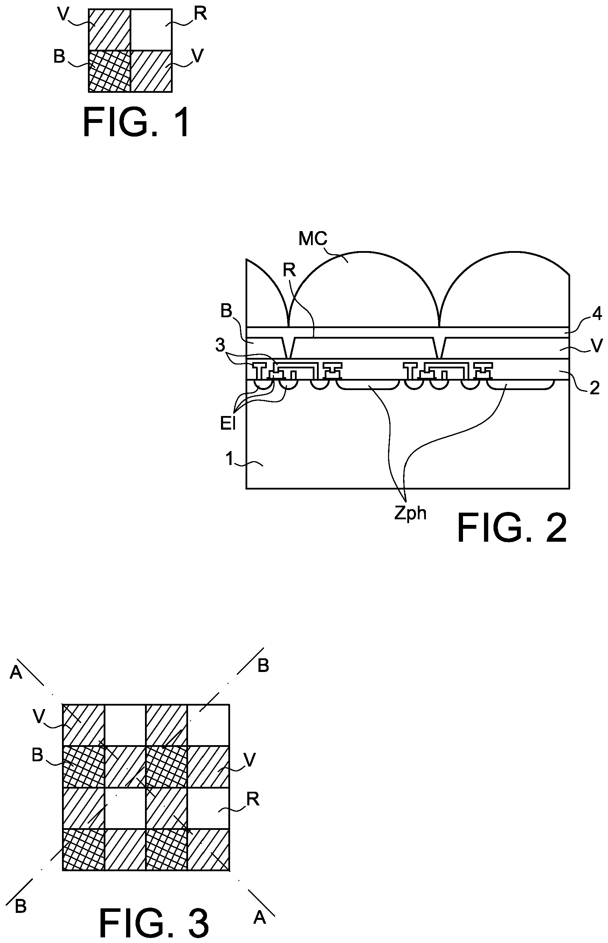

Un exemple de matrice de Bayer, vue de dessus, est représenté en figure 1. La matrice de Bayer représentée sur la figure 1 est une matrice 2x2 (deux lignes x deux colonnes). De gauche à droite, les filtres de la ligne de rang 1 sont des filtres respectivement vert et rouge, et les filtres de la ligne de rang 2 sont respectivement des filtres bleu, vert.

La réalisation d'une telle matrice filtrante se fait classiquement par l'utilisation de résines colorées. Afin de faciliter la réalisation de la matrice filtrante, il est fait appel à des résines photosensibles aux ultraviolets qui peuvent être éliminées dans un bain révélateur là où elles n'ont pas été insolées. Par exemple, pour réaliser une matrice de Bayer selon l'art antérieur, on dépose successivement trois couches de résine: une pour le vert, une pour le rouge et une pour le bleu. A chaque dépôt, chacune des résines est insolée à travers un masque et révélée pour ne rester que là où elle doit prendre place.

Le schéma de la figure 2 représente une structure simplifiée de capteur APS CMOS de l'art antérieur. Le capteur APS CMOS comprend un élément semi-conducteur photosensible 1, par exemple du silicium, à la surface duquel sont formées des zones photosensibles Zph et des circuits électroniques El, une couche de silice 2 dans laquelle sont intégrées des interconnexions électriques 3 qui relient entre eux les circuits électroniques El, des couches de résine formant des filtres bleu B, des filtres rouge R et des filtres vert V, une couche de résine 4 et un ensemble de microlentilles MC.

Cette technique de réalisation de capteur est à l'heure actuelle bien maîtrisée. Un inconvénient de ce capteur est cependant son impossibilité de filtrer l'infrarouge. Il est donc nécessaire d'ajouter, après coup, au dessus du capteur, une feuille de verre munie d'un filtre interférentiel multicouches pour éliminer l'infrarouge.

Par ailleurs, les résines ne sont pas très denses et il est actuellement nécessaire de mettre une épaisseur de résine voisine ou supérieure au micron pour avoir un effet de filtrage suffisant. La taille des pixels des capteurs d'images récents est en conséquence voisine de cette dimension (typiquement 2µm). Cette dimension des pixels pose alors un problème lorsque les rayons arrivent avec une forte incidence à la surface du capteur (bord d'image ou objectif fortement ouvert). En effet, les photons autorisés à traverser un filtre peuvent alors finir leur course dans le photo-site du filtre voisin. Ce phénomène limite donc considérablement la miniaturisation.

Les résines colorées sont également connues pour être facilement inhomogènes. L'inhomogénéité de filtrage est alors d'autant plus marquée que les pixels sont petits. Ceci représente également un autre inconvénient.

Par ailleurs, il existe d'autres matériaux absorbeurs que les résines mais, s'ils peuvent être plus absorbants, ces matériaux posent trop de problèmes de réalisation pour être compatibles avec une réalisation simple de matrice de photo-sites intégrés, laquelle réalisation devient alors trop coûteuse.

### Exposé de l'invention

L'invention ne présente pas les inconvénients mentionnés ci-dessus.

En effet, l'invention concerne une structure de filtrage optique selon la revendication 1. Des modes de réalisation additionnels étant définis dans les revendications dépendantes 2 à 5. L'invention concerne en outre un capteur optique selon la revendication 6, des modes de réalisation additionnels étant définis dans les revendications qui en dépendent.

Des filtres multicouches constitués d'une alternance de couches transparentes et de couches métalliques sont connus pour la réalisation de structures à bande interdite photonique, plus communément appelée structures PBG (PBG pour « Photonic Band Gap»). Ainsi, le brevet US 6 262 830 divulgue-t-il des structures transparentes métallo-diélectriques à bande interdite photonique.

Les structures transparentes métallo-diélectriques à bande interdite photonique divulguées dans le brevet US 6 262 830 sont constituées de la superposition d'une pluralité de couches diélectriques transparentes d'épaisseur voisine d'une demi-longueur d'onde séparées par des couches métalliques minces. L'épaisseur de chaque couche diélectrique ou métallique est uniforme. Ces structures sont conçues pour laisser passer certaines bandes de fréquences et pour en bloquer d'autres. Un inconvénient de ces structures est d'absorber une partie de la lumière, y compris dans les zones où on souhaiterait qu'elles soient transparentes. La publication japonaise JP 01271706 divulgue un filtre optique comprenant un film d'épaisseur variable sur un substrat.

De façon inattendue pour l'homme du métier, il est apparu que l'invention réalise une structure de filtrage optique adaptée à la transmission de certaines fréquences particulières par modification de l'épaisseur d'une seule ou de deux couches transparentes alors que, par ailleurs, toutes les autres couches sont d'épaisseur constante. Vue(s) en coupe, la ou les couches transparentes d'épaisseur variable varient en échelon en fonction de leur position dans la matrice.

Avantageusement, une structure de filtrage optique selon l'invention, par exemple une matrice de Bayer, peut alors être telle que tous les filtres optiques élémentaires de la matrice ont une épaisseur plus petite que la plus courte des longueurs d'ondes utiles.

### Brève description des figures

D'autres caractéristiques et avantages de l'invention apparaîtront à la lecture de modes de réalisation préférentiels de l'invention faits en référence aux figures jointes, parmi lesquelles :
- la figure 1, déjà décrite, représente une vue de dessus d'une matrice de Bayer selon l'art antérieur ;
- la figure 2, déjà décrite, représente une vue en coupe d'un capteur APS CMOS selon l'art antérieur ;
- la figure 3 représente une vue de dessus d'une structure matricielle de filtrage optique selon l'invention ;
- les figures 4A et 4B représentent des vues en coupe, selon deux axes différents, d'une structure matricielle de filtrage optique selon un premier mode de réalisation de l'invention ;
- la figure 5 représente les performances de filtrage optique d'une structure matricielle de filtrage optique selon le premier mode de réalisation de l'invention ;
- les figures 6A et 6B représentent des vues en coupe, selon deux axes différents, d'une structure matricielle de filtrage optique selon un deuxième mode de réalisation de l'invention ;
- la figure 7 représente les performances de filtrage optique d'une structure matricielle de filtrage optique selon le deuxième mode de réalisation de l'invention ;
- la figure 8 représente une vue en coupe de principe de capteur qui utilise une structure matricielle de filtrage optique selon le deuxième mode de réalisation de l'invention ;
- la figure 9 représente une première variante de capteur selon l'invention ;
- la figure 10 représente une première variante de capteur selon l'invention.

Sur toutes les figures, les mêmes références désignent les mêmes éléments.

### Description détaillée de modes de mise en œuvre de l'invention

La figure 3 représente une vue de dessus d'une structure matricielle de filtrage optique selon l'invention. Vue de dessus, la structure matricielle de filtrage optique de l'invention présente une géométrie obtenue par répétition de la structure de base de l'art antérieur représentée en figure 1. Des cellules de filtrage R, V, B pour sélectionner les couleurs respectives rouge, verte et bleue sont placées les unes à côté des autres.

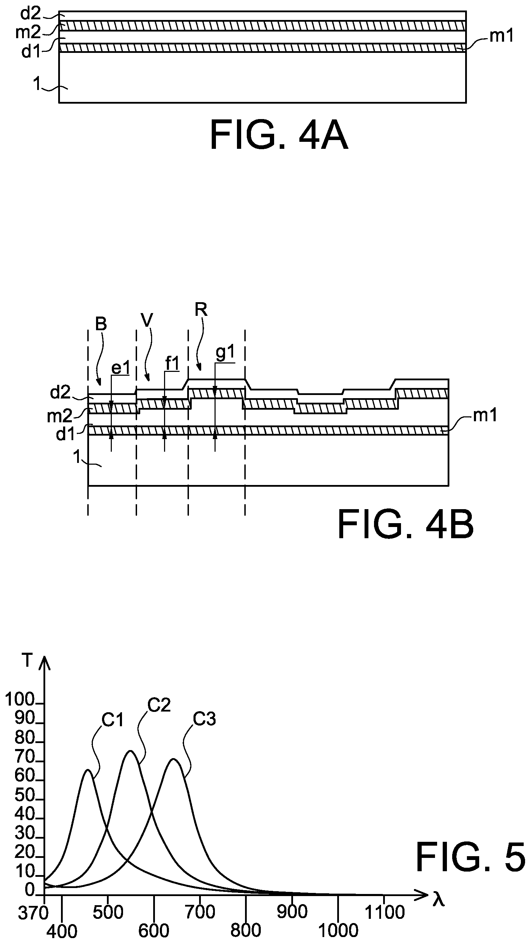

Les figures 4A et 4B représentent des vues en coupe, selon deux axes différents, d'une structure matricielle de filtrage optique selon un premier mode de réalisation de l'invention. En référence à la figure 3, la figure 4A est la vue en coupe selon l'axe AA de la figure 3 et la figure 4B est la vue en coupe selon l'axe BB de la figure 3. L'axe AA coupe en diagonale les filtres optiques vert V. L'axe BB est un axe perpendiculaire à l'axe AA et coupe, hors diagonales, des filtres optiques successifs bleu B, vert V, rouge R, vert V, bleu B, vert V, rouge R, etc.

Le capteur d'images comprend un élément semi-conducteur photosensible 1, par exemple du silicium, sur lequel sont posées, successivement, une première couche métallique m1, une première couche transparente d1, une deuxième couche métallique m2 et une deuxième couche transparente d2. Le métal utilisé pour réaliser les couches métalliques m1 et m2 est, par exemple, de l'argent (Ag) et le matériau utilisé pour réaliser les couches transparentes d1 et d2 est, par exemple, un diélectrique qui peut être, par exemple, du dioxyde de Titane (TiO₂).

La couche d1 est une couche de réglage dont la variation d'épaisseur fixe les différentes longueurs d'onde de transmission du filtre, toutes les autres couches ayant une épaisseur constante. La variation d'épaisseur de la couche d1 est ainsi adaptée à la transmission sélective de la couleur bleue (épaisseur e1), de la couleur verte (épaisseur f1) et de la couleur rouge (épaisseur g1).

Dans le cas particulier où les couches métalliques m1 et m2 sont des couches d'argent (Ag) et les couches transparentes d1 et d2 sont des couches de dioxyde de titane (TiO₂), les épaisseurs des couches m1, m2 et d2 sont respectivement égales, par exemple, à 27nm, 36nm et 41nm et l'épaisseur de la couche d1 varie entre 50nm et 90nm, à savoir : 52 nm pour le bleu, 70 nm pour le vert, 87nm pour le rouge.

Les épaisseurs des couches prendraient des valeurs différentes avec d'autres matériaux. A titre, d'exemples non limitatifs, les couches métalliques peuvent être faites de Ag, Al, Au, Nb, Li et les couches transparentes peuvent être faites de TiO₂, ITO, SiO₂, Si₃N₄, MgF₂, SiON, Al₂O₃, HfO₂. De façon générale, les épaisseurs des couches m1, d1, m2, d2 sont calculées à l'aide d'algorithmes de calculs de filtre multicouches.

Il faut ici remarquer que, sur les figures 4A et 4B (et il en est de même sur l'ensemble des autres figures), l'épaisseur des couches est délibérément grossie afin de mieux visualiser les variations d'épaisseur.

La figure 5 représente les performances de filtrage optique d'une structure matricielle de filtrage selon le premier mode de réalisation de l'invention. Trois courbes sont représentées sur la figure 5, à savoir une courbe de transmission C1 relative à la couleur bleu (pour les filtres bleu), une courbe de transmission C2 relative à la couleur verte (pour les filtres vert) et une courbe de transmission C3 relative à la couleur rouge (pour les filtres rouge). Les courbes C1, C2, C3 représentent le coefficient de transmission T de la structure matricielle exprimé en pourcentages en fonction de la longueur d'onde λ exprimée en nm.

Il faut ici noter non seulement l'excellente qualité des résultats de transmission obtenus avec seulement quatre couches (transmission atteignant sensiblement 70%), mais également l'excellente réjection des ondes infrarouges au-delà de 900nm.

Par ailleurs, les filtres optiques ne présentent qu'un seul pic de transmission entre le proche ultraviolet (400nm) et l'infrarouge (1100 nm). Ceci est également un avantage par rapport aux structures diélectriques de l'art antérieur qui présentent toujours une transmission parasite dans le proche infrarouge (>800 nm).

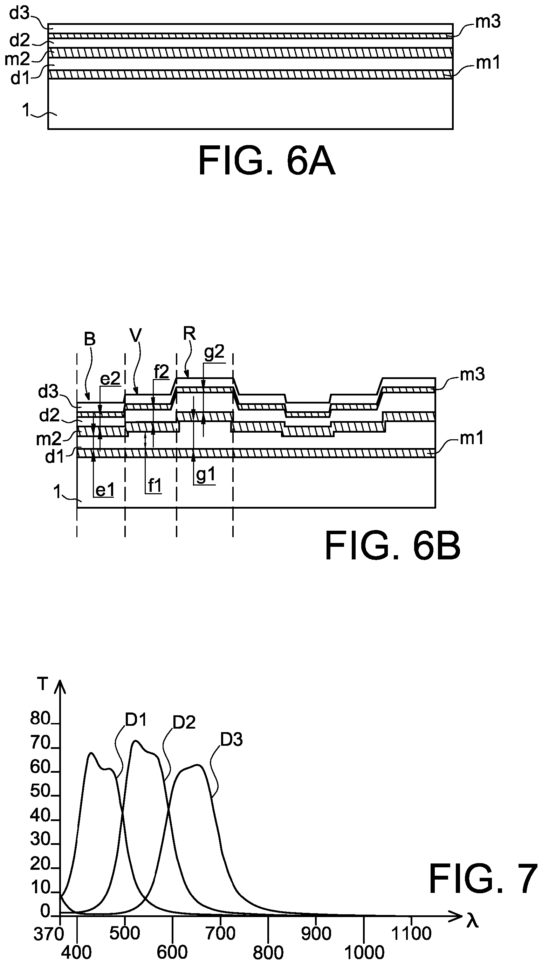

Les figures 6A et 6B représentent des vues en coupe, selon deux axes différents, d'une structure matricielle de filtrage optique selon un deuxième mode de réalisation de l'invention. En référence à la figure 3, la figure 6A est une vue en coupe selon l'axe AA et la figure 6B est une vue en coupe selon l'axe BB.

Le capteur d'images comprend un élément semi-conducteur photosensible 1, par exemple du silicium, sur lequel sont posées, en alternance, trois couches métalliques m1, m2, m3 et trois couches transparentes d1, d2, d3, la couche métallique m1 étant au contact de l'élément semi-conducteur 1. Les couches métalliques m1-m3 sont, par exemple, en argent (Ag) et les couches transparentes d1-d3 sont, par exemple, en dioxyde de Titane (TiO₂).

Les couches d1 et d2 sont les couches de réglage dont les variations d'épaisseur fixent les différentes longueurs d'onde de transmission du filtre, toutes les autres couches ayant une épaisseur constante. Une surépaisseur résultant d'une variation d'épaisseur de la couche d1 coïncide avec une surépaisseur résultant d'une variation d'épaisseur de la couche d2 (les surépaisseurs s'empilent). La couche d3 est une couche anti-reflets. Les variations d'épaisseur des couches d1 et d2 sont ainsi adaptées à la transmission sélective des différentes couleurs :
- une épaisseur e1 de la couche d1 et une épaisseur e2 de la couche d2 sont associées pour une transmission sélective de la couleur bleue ;
- une épaisseur f1 de la couche d1 et une épaisseur f2 de la couche d2 sont associées pour une transmission sélective de la couleur verte ; et
- une épaisseur g1 de la couche d1 et une épaisseur g2 de la couche d2 sont associées pour une transmission sélective de la couleur rouge.

Dans le cas particulier de couches métalliques en argent (Ag) et de couches transparentes en dioxyde de titane (TiO₂), les épaisseurs des couches m1, m2, m3 et d3 sont respectivement égales, par exemple, à 23nm, 39nm, 12nm et 65nm, les épaisseurs des couches d1 et d2 étant comprises entre 50nm et 100nm, à savoir :

| | d₁ | d₂ |
|---|---|---|
| Bleu | 52 nm | 51,4 nm |
| Vert | 70 nm | 73,5 nm |
| Rouge | 87,5 nm | 96 nm |

Le spectre en transmission résultant de cette structure matricielle est représenté en figure 7. Les courbes D1, D2, D3 représentent le coefficient de transmission T de la structure matricielle exprimé en pourcentages en fonction de la longueur d'onde λ exprimée en nm. Aux longueurs d'ondes centrales qui correspondent aux trois couleurs souhaitées (rouge, vert, bleu), la transmission est sensiblement comprise entre 60 et 70%.

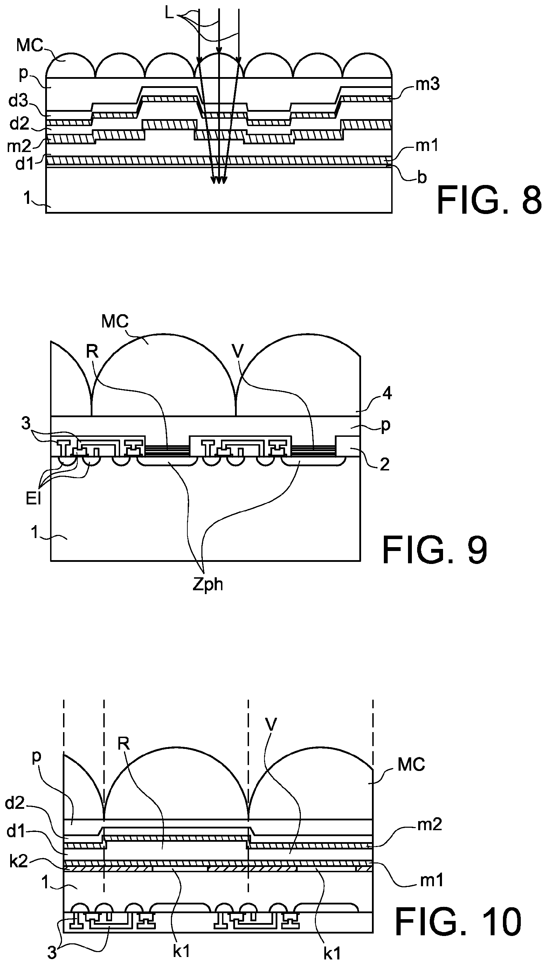

La figure 8 représente une vue en coupe d'un perfectionnement d'une structure matricielle de filtrage optique selon le deuxième mode de réalisation de l'invention. La structure matricielle est ici équipée d'un ensemble de microlentilles MC qui focalisent la lumière L dans les photo-sites. De façon connue en soi, les microlentilles MC sont placées sur une couche p de planarisation.

Outre les éléments déjà décrits en référence aux figures 6A et 6B, l'ensemble de microlentilles MC et la couche de planarisation p, la structure matricielle de l'invention comprend ici une couche barrière b qui protège le semi-conducteur 1 de la couche métallique m1. La couche barrière b empêche alors que le semi-conducteur 1 ne soit pollué par la couche métallique m1 (pollution par migration d'ions métalliques dans le semi-conducteur). Dans le cas où, par exemple, le métal est l'argent (Ag), une couche barrière de silice ou une couche d'oxyde d'étain dopé indium (ITO en langue anglaise pour « Indium Tin Oxide ») permet de réaliser la protection souhaitée. L'épaisseur des couches de silice ou de ITO est, par exemple, égale à 10nm.

La couche barrière b peut être non conductrice (c'est le cas de la silice SiO₂ et du nitrure de silicium Si₃N₄), conductrice (c'est le cas de l'ITO) ou partiellement conductrice. Lorsqu'elle est conductrice, la couche barrière b peut avantageusement servir d'électrode à la surface du semi-conducteur 1. Avantageusement, dans le cas où la couche barrière est une couche d'ITO, l'ITO peut également servir à réaliser les couches transparentes de la structure, l'ITO étant transparent. Les couches b, d1, d2, d3 sont alors en ITO et les couches m1, m2, m3 sont en Ag. Deux matériaux (Ag et ITO) suffisent alors pour réaliser une structure selon l'invention dans laquelle le semi-conducteur photosensible est protégé d'un contact avec le métal. Il est également possible de remplacer l'argent par un alliage métallique moins polluant pour le semi-conducteur mais ayant encore les bonnes propriétés d'indice. L'alliage métallique et l'ITO suffisent alors également pour réaliser une structure selon l'invention dans laquelle le semi-conducteur photosensible est protégé.

Les figures 9 et 10 représentent deux variantes de capteur optique selon l'invention.

La figure 9 représente un capteur optique dans lequel la lumière arrive sur la face du semi-conducteur photosensible sur laquelle sont formées les zones photosensibles Zph et les circuits électroniques El. Dans ce type de capteur optique, la lumière doit éviter les interconnexions métalliques 3. Les filtres optiques de l'invention sont généralement beaucoup plus minces que les filtres de l'art antérieur. Il est alors avantageux de placer les filtres au plus près des zones photosensibles Zph, entre les interconnexions 3. Comparativement à la structure correspondante de l'art antérieur (cf. figure 2), le capteur optique a en conséquence une meilleure insensibilité à l'incidence de la lumière.

La figure 10 représente un capteur optique dans lequel la lumière arrive sur la face du semi-conducteur photosensible qui est opposée à la face sur laquelle sont formées les zones photosensibles Zph et les circuits électroniques El. La matrice de filtrage optique de l'invention s'adapte très facilement à ce type de capteur. Ici aussi, le capteur optique de l'invention a une épaisseur avantageusement moindre qu'un capteur optique correspondant de l'art antérieur. Par ailleurs, dans certaines applications, la proximité des filtres optiques permet avantageusement de supprimer les microlentilles MC.

Selon un mode de réalisation particulier, le capteur représenté en figure 10 comprend, entre le semi-conducteur 1 et la première couche métallique m1, une couche barrière b munie de zones électriquement conductrices k1 et de zones électriquement isolantes k2. Les zones conductrices k1 et isolantes k2 permettent d'établir des contacts électriques aux endroits souhaités.

Les deux structures particulières représentées aux figures 9 et 10 présentent avantageusement un spectre de transmission qui varie très peu avec l'angle d'incidence de la lumière. Ainsi, par exemple, un filtre vert (TiO₂/Ag) présentant une largeur de filtre de 90 nm voit-il sa longueur d'onde moyenne varier de sensiblement 20 nm lorsque l'incidence varie de 0° à 40°. Comparativement, cette variation serait de 38 nm pour un filtre multicouches de l'art antérieur (SiO₂/TiO₂).

Un autre avantage des structures de filtrage de l'invention est qu'elles peuvent être réalisées avec des matériaux tels que l'argent et l'ITO qui sont des conducteurs électriques, ce qui permet de faire jouer au filtre un rôle d'électrode, cette électrode pouvant avoir plusieurs points de contact avec le circuit sous-jacent (El, Zph).

La réalisation technologique des structures de filtrage et des capteurs de l'invention est assez simple et utilise des procédés de fabrication usuels du domaine de la micro-électronique.

Préférentiellement les couches transparentes et les couches métalliques sont réalisées par pulvérisation sous vide mais d'autres techniques sont également possibles telles que, par exemple, l'évaporation sous vide. Le contrôle des épaisseurs se fait par la connaissance de la vitesse des dépôts.

Le procédé de réalisation d'un exemple de structure de filtrage optique à une seule couche transparente d'épaisseur variable est décrit ci-après.

Sur un substrat semi-conducteur photosensible sont successivement déposées une couche de protection (SiO₂), une couche métallique (argent) et une couche de matériau transparent (ITO). Ensuite sont réalisées deux étapes de photolithographie-gravure. Le masquage des zones ne devant pas être gravées est fait par de la résine. La gravure est faite, de préférence, en gravure ionique réactive (par exemple sous gaz Chlore + HBr pour graver l'ITO). Le point d'arrêt de la gravure est déterminé par un interféromètre. A titre d'exemple non limitatif, à partir d'une couche d'ITO de 90nm d'épaisseur, il est possible d'obtenir une épaisseur d'ITO de 70nm pour le vert, de 50nm pour le bleu, l'épaisseur initiale de 90nm étant conservée pour le rouge. Une couche d'argent (Ag) et une couche d'ITO ayant, chacune, une épaisseur constante sont ensuite successivement déposées.

Le procédé de réalisation d'un exemple de structure de filtrage optique à deux couches transparentes d'épaisseurs variables est décrit ci-après.

Le procédé est quasiment identique à celui décrit ci-dessus pour une seule couche transparente d'épaisseur variable, à savoir :
- dépôt des trois premières couches (couche de protection en Si0₂, première couche d'Ag, première couche d'ITO);
- réalisation de deux étapes de photolithographie-gravure pour faire les échelons transparents de la première couche d'ITO ;
- dépôt des deux couches suivantes (deuxième couche d'Ag, deuxième couche d'ITO) ;
- réalisation de deux nouvelles étapes de photolithographie-gravure pour réaliser les échelons transparents de la deuxième couche transparente ;
- dépôt des deux dernières couches d'épaisseur constante (Ag, ITO).

Comme cela a déjà été mentionné précédemment, de façon avantageuse, l'invention prévoit que la couche de protection peut être plus compliquée à réaliser qu'une simple couche diélectrique. Par exemple, si l'on veux se servir d'un filtre élémentaire comme électrode conductrice, alors on est obligé de remplacer la couche de protection isolante par une couche de protection conductrice aux emplacements où la couche de protection est en contact électrique avec le semi-conducteur photosensible.

La réalisation d'une telle couche à deux matériaux, par exemple SiO₂ pour réaliser les zones isolantes et ITO pour réaliser les zones conductrices, est réalisée en quatre étapes, à savoir :
- dépôt d'une couche de Si0₂ ;
- photolithographie et gravure du Si0₂ là où l'on veut mettre de l'ITO ;
- dépôt d'une couche d'ITO un peu plus épaisse que la couche de Si0₂ ;
- planarisation mécano-chimique éliminant l'ITO jusqu'à la surface du Si0₂.

## Revendications

1. Structure de filtrage optique composée d'un ensemble d'au moins deux filtres optiques élémentaires (R, V, B), un filtre optique élémentaire étant centré sur une fréquence de transmission optimale, comprenant un empilement de n couches métalliques (m1, m2, m3) et de n couches sensiblement transparentes (d1, d2, d3) qui alternent entre une première couche métallique (m1) et une n^{ième} couche sensiblement transparente (d3), les n couches métalliques (m1, m2, m3) ayant chacune une épaisseur constante et une seule ou deux couches sensiblement transparentes ayant une épaisseur variable qui fixe la fréquence de transmission optimale d'un filtre optique élémentaire, la ou les autres couches sensiblement transparentes présentant une épaisseur constante, n étant un entier supérieur ou égal à 2,
**caractérisé en ce que** dans la structure de filtrage n=3 et dans laquelle deux couches sensiblement transparentes ont une épaisseur variable, une première couche sensiblement transparente qui a une épaisseur variable étant la couche sensiblement transparente située entre la première couche métallique (m1) et une deuxième couche métallique (m2) et la deuxième couche sensiblement transparente qui a une épaisseur variable étant située entre la deuxième couche métallique et une troisième couche métallique (m3), une surépaisseur résultant d'une variation d'épaisseur de la première couche sensiblement transparente s'empilant sensiblement avec une surépaisseur résultant d'une variation d'épaisseur de la deuxième couche sensiblement transparente.

2. Structure de filtrage optique selon la revendication 1, dans laquelle les filtres optiques élémentaires (R, V, B) sont disposés sous forme de matrice.

3. Structure de filtrage optique selon la revendication 2, dans laquelle la matrice est une matrice de Bayer pour le filtrage des trois couleurs rouge, vert et bleu.

4. Structure de filtrage optique selon l'une quelconque des revendications précédentes, dans laquelle les couches métalliques sont en argent (Ag).

5. Structure de filtrage optique selon l'une quelconque des revendications précédentes, dans laquelle le matériau qui compose les couches sensiblement transparentes est choisi parmi le dioxyde de titane (TiO₂), l'oxyde d'étain dopé indium (ITO), la silice (SiO₂), le nitrure de silicium (Si₃N₄), l'oxyde d'hafnium (HfO₂).

6. Capteur optique comprenant une structure de filtrage optique et un substrat semi-conducteur photosensible (1) sur lequel est déposée la structure de filtrage optique, **caractérisé en ce que** la structure de filtrage optique est une structure selon l'une quelconque des revendications 1 à 5, la première couche métallique (m1) étant déposée sur une première face du substrat semi-conducteur (1).

7. Capteur optique comprenant une structure de filtrage optique et un substrat semi-conducteur photosensible (1) sur lequel est déposée la structure de filtrage optique, **caractérisé en ce que** la structure de filtrage optique est une structure selon l'une quelconque des revendications 1 à 5 et **en ce qu'**il comprend une couche barrière (b) dont une première face est déposée sur une première face du substrat semi-conducteur (1) et dont une deuxième face est en contact avec la première couche métallique (m1).

8. Capteur optique selon la revendication 7, dans lequel la couche barrière est faite dans un matériau identique au matériau qui constitue les couches sensiblement transparentes de la structure de filtrage optique.

9. Capteur optique selon la revendication 7 ou 8, dans lequel la couche barrière (b) est partiellement ou totalement électriquement conductrice.

10. Capteur optique selon la revendication 9, dans lequel le matériau de la couche barrière est l'oxyde d'étain dopé indium (ITO) dans les parties électriquement conductrices et la silice (SiO₂) ou le nitrure de silicium (Si₃N₄) dans les parties qui ne sont pas électriquement conductrices.

11. Capteur optique selon l'une quelconque des revendications 6 à 10, dans lequel des zones photosensibles (Zph) et des composants électroniques (El) sont formés sur la première face du semi-conducteur photosensible.

12. Capteur optique selon l'une quelconque des revendications 6 à 10, dans lequel des zones photosensibles (Zph) et des composants électroniques (El) sont formés sur une deuxième face du semi-conducteur photosensible (1), opposée à la première face.

## Patentansprüche

1. Struktur zur optischen Filterung, gebildet durch eine Anordnung von wenigstens zwei optischen Elementarfiltern (R, V, B), wobei ein optisches Elementarfilter auf eine optimale Transmissionsfrequenz zentriert ist, umfassend einen Stapel von n metallischen Schichten (m1, m2, m3) und von n im Wesentlichen transparenten Schichten (d1, d2, d3), die zwischen einer ersten metallischen Schicht (m1) und einer n-ten im Wesentlichen transparenten Schicht (d3) alternieren, wobei die n metallischen Schichten (m1, m2, m3) jeweils eine konstante Dicke haben, und wobei eine einzige oder zwei im Wesentlichen transparente Schichten eine variable Dicke haben, die die optimale Transmissionsfrequenz eines optischen Elementarfilters fixiert, wobei die andere(n) im Wesentlichen transparente(n) Schicht(en) eine konstante Dicke aufweist/aufweisen, wobei n eine ganze Zahl größer oder gleich 2 ist,
**dadurch gekennzeichnet, dass** in der Filterungsstruktur n=3 ist, und wobei zwei im Wesentlichen transparente Schichten eine variable Dicke haben, wobei eine erste im Wesentlichen transparente Schicht, die eine variable Dicke hat, die im Wesentlichen transparente Schicht ist, die zwischen der ersten metallischen Schicht (m1) und einer zweiten metallischen Schicht (m2) angeordnet ist, und wobei die zweite im Wesentlichen transparente Schicht, die eine variable Dicke hat, zwischen der zweiten metallischen Schicht und einer dritten metallischen Schicht (m3) angeordnet ist, wobei eine Verdickung, die aus einer Variation der Dicke der ersten im Wesentlichen transparenten Schicht resultiert, im Wesentlichen auf eine Verdickung gestapelt ist, die aus einer Variation der Dicke der zweiten im Wesentlichen transparenten Schicht resultiert.

2. Struktur zur optischen Filterung nach Anspruch 1, bei der die optischen Elementarfilter (R, V, B) in Form einer Matrix angeordnet sind.

3. Struktur zur optischen Filterung nach Anspruch 2, bei der die Matrix eine Bayer-Matrix für die Filterung der drei Farben rot, grün und blau ist.

4. Struktur zur optischen Filterung nach einem der vorhergehenden Ansprüche, bei der die metallischen Schichten aus Silber (Ag) sind.

5. Struktur zur optischen Filterung nach einem der vorhergehenden Ansprüche, bei der das Material, aus dem die im Wesentlichen transparenten Schichten gebildet sind, ausgewählt ist aus Titandioxid (TiO₂), mit Indium dotiertes Zinnoxid (ITO), Siliziumoxid (SiO₂), Siliziumnitrid (Si₃N₄), Hafniumoxid (HfO₂).

6. Optischer Sensor, umfassend eine Struktur zur optischen Filterung und ein lichtempfindliches Halbleitersubstrat (1), auf dem die Struktur zur optischen Filterung aufgebracht ist, **dadurch gekennzeichnet, dass** die Struktur zur optischen Filterung eine Struktur nach einem der Ansprüche 1 bis 5 ist, wobei die erste metallische Schicht (m1) auf einer ersten Fläche des Halbleitersubstrats (1) aufgebracht ist.

7. Optischer Sensor, umfassend eine Struktur zur optischen Filterung und ein lichtempfindliches Halbleitersubstrat (1), auf dem die Struktur zur optischen Filterung aufgebracht ist, **dadurch gekennzeichnet, dass** die Struktur zur optischen Filterung eine Struktur nach einem der Ansprüche 1 bis 5 ist, und dass er eine Barriereschicht (b) umfasst, von der eine erste Fläche auf einer ersten Fläche des Halbleitersubstrats (1) aufgebracht ist, und von der eine zweite Fläche in Kontakt mit der ersten metallischen Schicht (m1) ist.

8. Optischer Sensor nach Anspruch 7, bei dem die Barriereschicht aus einem Material identisch zu dem Material hergestellt ist, das die im Wesentlichen transparenten Schichten der optischen Filterungsstruktur bildet.

9. Optischer Sensor nach Anspruch 7 oder 8, bei dem die Barriereschicht (b) partiell oder vollständig elektrisch leitend ist.

10. Optischer Sensor nach Anspruch 9, bei dem das Material der Barriereschicht mit Indium dotiertes Zinnoxid (ITO) in den elektrisch leitenden Teilen ist sowie Siliziumoxid (SiO₂) oder Siliziumnitrid (Si₃N₄) in den Teilen, die nicht elektrisch leitend sind.

11. Optischer Sensor nach einem der Ansprüche 6 bis 10, bei dem lichtempfindliche Zonen (Zph) und elektronische Bauteile (E1) auf der ersten Fläche des lichtempfindlichen Halbleiters gebildet sind.

12. Optischer Sensor nach einem der Ansprüche 6 bis 10, bei dem lichtempfindliche Zonen (Zph) und elektronische Bautele (E1) auf einer zweiten Fläche des lichtempfindlichen Halbleiters (1) entgegengesetzt zu der ersten Fläche gebildet sind.

## Claims

1. An optical filtering structure consisting of a set of at least two elementary optical filters (R, V, B), an elementary optical filter being centered on an optimum transmission frequency, comprising a stack of n metal layers (m1, m2, m3) and of n substantially transparent layers (d1, d2, d3) which alternate between a first metal layer (m1) and an n^{th} substantially transparent layer (d3), each of the n metal layers (m1, m2, m3) having a constant thickness and at least one substantially transparent layer having a variable thickness which sets the optimum transmission frequency of an elementary optical filter, n being an integer larger than or equal to 2,
**Characterized in that** in the filtering structure, n=3 and wherein two substantially transparent layers have a variable thickness, a first substantially transparent layer which has a variable thickness being the substantially transparent layer located between the first metal layer (m1) and a second metal layer (m2) and the second substantially transparent layer which has a variable thickness being located between the second metal layer and a third metal layer (m3), an overthickness resulting from a change in thickness of the first substantially transparent layer substantially stacked with an overthickness resulting from a change in thickness of the second substantially transparent layer.

2. The optical filtering structure according to claim 1, wherein the elementary optical filters (R, V, B) are arranged as a matrix.

3. The optical filtering structure according to claim 2, wherein the matrix is a Bayer matrix for filtering the three colors, red, green and blue.

4. The optical filtering structure according to any of the preceding claims, wherein the metal layers are in silver (Ag).

5. The optical filtering structure according to any of the preceding claims, wherein the material which makes up the substantially transparent layers is selected from titanium dioxide (TiO₂), indium-doped tin oxide (ITO), silica (SiO₂), silicon nitride (Si₃N₄), hafnium oxide (HfO₂).

6. An optical sensor comprising an optical filtering structure and a photosensitive semiconducting substrate (1) on which is deposited the optical filtering structure, **characterized in that** the optical filtering structure is a structure according to any of claims 1 to 5, the first metal layer (m1) being deposited on a first face of the semiconducting substrate (1).

7. The optical sensor comprising an optical filtering structure and a photosensitive semiconducting substrate (1) on which is deposited the optical filtering structure, **characterized in that** the optical filtering structure is a structure according to any of claims 1 to 7 and **in that** it comprises a barrier layer (b), a first face of which is deposited on a first face of the semiconducting substrate (1) and a second face of which is in contact with the first metal layer (m1).

8. The optical sensor according to claim 9, wherein the barrier layer is made in a material identical with the material which makes up the substantially transparent layers of the optical filtering structure.

9. The optical sensor according to claim 7 or 8, wherein the barrier layer (b) is partly or totally electrically conducting.

10. The optical sensor according to claim 11, wherein the material of the barrier layer is indium-doped tin oxide (ITO) in the electrically conducting portions and silica (SiO₂) or silicon nitride (Si₃N₄) in the portions which are not electrically conducting.

11. The optical sensor according to any of claims 6 to 10, wherein photosensitive areas (Zph) and electronic components (El) are formed on the first face of the photosensitive semiconductor.

12. The optical sensor according to any of claims 6 to 10, wherein photosensitive areas (Zph) and electronic components (El) are formed on a second face of the photosensitive semiconductor (1), opposite to the first face.
